Europäisches Patentamt

European Patent Office

Office européen des brevets

(11) Publication number: **0 244 259**
B1

# EUROPEAN PATENT SPECIFICATION

(45) Date of publication of the patent specification:
18.10.89

(21) Application number: 87303908.5

(22) Date of filing: 30.04.87

(51) Int. Cl.⁴: **G 01 M 11/00, C 25 D 13/12,**
**G 02 F 1/133**

(54) Method of detecting the presence or absence of defect of transparent circuit board having fine transparent electric conductive circuit.

(30) Priority: 01.05.86 JP 101714/86

(43) Date of publication of application:
04.11.87 Bulletin 87/45

(45) Publication of the grant of the patent:
18.10.89 Bulletin 89/42

(84) Designated Contracting States:
DE FR GB IT NL

(56) References cited:
EP-B-0 071 872

(73) Proprietor: SHINTO PAINT CO., LTD., 10-73,
Minami-Tsukaguchicho 6-chome, Amagasaki (JP)

(72) Inventor: Tameyuki, Suzuki, 1-7 Yamanone 3-chome,
Zushi Kanagawa-ken (JP)
Inventor: Junichi, Yasukawa, 13-13, Higashikaigan
Minami, 2-chome, Chigasaki Kanagawa-ken (JP)
Inventor: Toyokazu, Nomura, 1-1 Higashi
Narashino 5-chome, Narashino Chiba-ken (JP)

(74) Representative: Pennant, Pyers et al, Stevens, Hewlett &
Perkins 5 Quality Court Chancery Lane, London,
WC2A 1HZ (GB)

## Description

The present invention relates to a method of detecting the presence or absence of a defect of a transparent circuit board having fine transparent electric conductive circuits.

In detecting the presence or absence of a defect of a transparent circuit board having fine transparent electric conductive circuits, a method of examining it with the naked eye by enlarging the circuits by a microscope or the like or a method of judging it by checking the electric conduction or the resistance between the circuits have conventionally been adopted.

These conventional methods, however, have various defects. For example, it is difficult to detect the presence or absence of a defect on the circuits by examination with the naked eye (or by an optical method), because, since transparent electric conductive circuits are formed on a transparent circuit board, the difference of the refractive indexes between the portion at which the circuits are formed and the portion at which no circuit is formed is small. Furthermore, the finer the circuits are, the more difficult is the detection. On the other hand, in the electrical detection method, a defect on the circuits is fundamentally detected by examining the conduction in a circuit or the conduction (short-circuit) between adjacent circuits. Therefore, the finer the circuits are, the more difficult becomes the technical problem in the design of a probe which is suitable for the fine circuits, and the more expensive is the cost.

Accordingly, it is an object of the present invention to provide a method which facilitates the detection of a defect on a transparent circuit board having fine transparent electric conductive circuits.

As a result of the present inventors' various investigations on a method of overcoming the above-described defects in the prior art and economically detecting the presence or absence of a defect on a transparent circuit board having fine transparent electric conductive circuits, it has been found that it is easy to attain this aim by intensifying the contrast of the colors of the conductive circuit portion and non-conductive circuit portion by coloring solely the conductive circuit portions by electrodeposition, which has the electrical characteristics of very faithfully coloring the conductive circuit portions solely. The present invention has been achieved on the basis of this finding.

The present invention provides a method of detecting the presence or absence of a defect on a transparent circuit board having fine transparent electric conductive circuits by coloring the transparent electric conductive circuits in an electrodeposition coating bath by electrodeposition.

The electrodeposition coating adopted in the present invention is a method comprising the steps of making an electrodeposition coating bath by dissolving or dispersing in the form of fine particles a colouring matter and an electric charge doping agent in water or a nonaqueous medium; putting the circuit board, which is an object to be examined, and an opposing electrode into the bath; and applying a voltage between the transparent electric conductive circuits and the opposing electrode, thereby coloring the necessary electric conductive circuit portions of the object to be examined.

The structure of the above-described electrodeposition will be explained in detail in the following.

The main constituents of the electrodeposition coating bath are a colouring matter, an electric charge doping agent, and a medium in which the colouring matter and the electric charge doping agent are dissolved or dispersed.

As the colouring matter, a colouring matter of a color which is suitable for distinctly discriminating the colored portions of the electric conductive circuits from the non-electrodeposited portions is used. Both dyes and pigments are usable. Carbon black, iron oxide, phthalocyanine and disazo pigments or dyes are generally used, because they are cheap and stable.

As the electric charge doping agent, a high polymer compound having a polar group is generally usable. When a nonaqueous medium is used, an inorganic or organic monomeric substance which can be ionized in the medium is also usable. When the medium is water, a polycarboxylic acid polymer or a polyamide polymer is usable as a high polymer. In the case of using a polycarboxylic acid polymer, an alkaline substance is brought into reaction therewith to dissociate it in the water, electrify the negative pole, coalesce it with the colouring matter in the electrodeposition coating bath and electrodeposit it to the positive pole in the bath. In the case of using a polyamine polymer, an acide substance is brought into reaction therewith to dissociate it in the water, electrify the positive pole, coalesce it with the colouring matter in the electrodeposition coating bath and electrodeposit it to the negative pole in the bath. The polycarboxylic polymer is exemplified by acrylic, polyester, maleinized oil, epoxy and polyolefin polymers, and the polyamine polymer is exemplified by epoxy, urethane, polyolefin and acrylic polymers.

In case of a transparent circuit board which is generally used, an electrodeposition coating bath which uses a polycarboxylic acid polymer is preferable, because its chemical nature prevents an object to be examined from assuming a reducing atmosphere at the time of electrodeposition.

As a nonaqueous medium, hydrocarbon, alcohol, ester and ketone are usable. Since it is preferable that the resistivity of the medium is not more than $10^{11}$ $\Omega$cm for the purpose of adhering the colouring matter solely to the conductive circuit portions of the electric conductive circuits, alcohol, ester and ketone are preferable media. If the resistivity of the medium exceeds $10^{11}$ $\Omega$cm, the colouring matter is unfavorably likely to adhere to the non-conductive circuit portions, thereby making it difficult to discriminate a defect of a circuit. As an electric charge doping agent used in the nonaqueous medium, a monomeric substance which can be ionized is usable as well as a polymer having a polarity. As the examples of the monomeric substances, an organic acid such as sulfuric acid and phosphoric acid; an alkaline substance such as sodium hydroxide and tetramethylammonium hydroxide; and metal salts such as calcium naphthenate, zirconium octylate, lanthanum nitrate and aluminium nitrate will be cited. These substances are usable singly or in the form of a mixture.

In order to provide the electrodeposition coating bath with practicality such as bath stability, a surfactant, dispersant, etc., are preferably added to the above-described constituents.

The electrodeposition coating bath generally contains 1 to 20 wt% solid content and is used at a temperature of 10 to 30° C. In the case of a nonaqueous medium, it is usable in a lower solid content range. In order not to electrically damage an object to be examined, it is preferable to limit the ionic substance to the necessary minimum.

Electrodeposition is carried out by putting a transparent circuit board, which is an object to be examined, and an opposing electrode into the electrodeposition coating bath, and applying a direct current voltage between the transparent electric conductive circuits on the transparent circuit board and the opposing electrode. A voltage of several V to several hundred V is applied for about not more than 30 seconds. It is preferable that a comparatively high voltage is applied for a short time in the case of a nonaqueous medium, while a low voltage is applied in the case of a water medium.

The object to be examined is a transparent substrate of glass or a plastic material with a transparent electric conductive material such as ITO (tin-doped indium oxide) or NESA (antimony-doped tin oxide) patterned in the form of a circuit thereon. The patterned transparent board is connected to an external power source so as to electrodeposit the colouring matter on the transparent electric conductive circuits. For example, for an electrode of a matrix liquid crystal display device transparent electric conductive circuits of about 100 to 400 μ wide are generally formed in the form of stripes with spaces of about 20 to 50 μ on a glass substrate material. In this case, every other line is first colored by electrodeposition, and the lines which have not been subjected to the electrodeposition are next colored with a different color by electrodeposition. If a line is disconnected, the disconnected portion of the line is not colored, and a defect of the stripe is pointed out. If there is a short-circuit between adjacent circuits, a non-conductive circuit portion which is not to be colored in the first electrodeposition is colored.

As described above, according to the present invention, it is easy to discriminate not only between a non-circuit portion (glass substrate material) and a transparent electric conductive circuit portion but also between the non-conductive circuit portion (disconnected portion) and the conductive circuit portion, or the presence or absence of a short-circuit portion by coloring those portions with a colouring matter by electrodeposition.

Furthermore, the method of the present invention which utilizes coloring electrically is characterized in that the electric conductivity of an electric conductive circuit is replaced by a color for discrimination.

If the existence of the electrodeposited colouring matter is unfavorable after discrimination, it is removed by an appropriate cleaning agent such as an organic solvent, and is further cleaned by an ordinary method so as not to damage the function as an electrode.

The present invention will be described with reference to the examples and by referring partly to the accompanying drawings wherein:

Figs. 1 and 2 are schematic plan views of a transparent circuit board having transparent electric conductive circuits; and

Figs. 3 and 4 are schematic plan views of the circuit boards shown in Figs. 1 and 2, respectively, with a copper tape pasted thereto in order to subject them for electrodeposition.

1. A transparent circuit board (an object to be examined) having transparent electric conductive circuits:

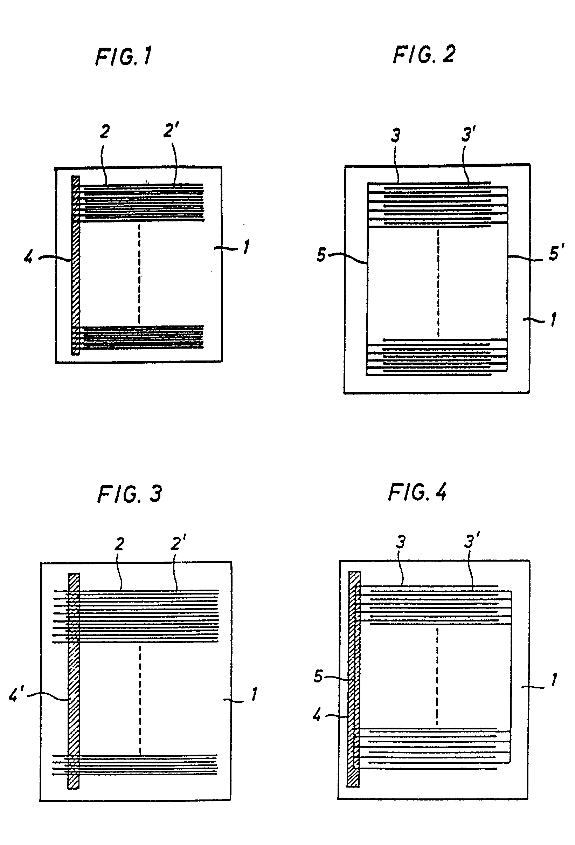

(A) On a glass substrate 1 of 1.1 mm in thickness and 15 cm × 10 cm in area, ITO circuits (60 Ω/square) 2 and 2' of 200 μ wide were formed in parallel lines with spaces of 40 μ (240 μ pitch), as shown in Fig. 1. At this tie, one end of each of the ITO circuits 2 was formed to be longer by 5 mm than the adjacent one, as shown in Fig. 1, while the other end was formed to have the same length.

(B) On a glass substrate 1 of 1.1 mm in thickness and the size A4, ITO circuits (10 Ω/square) of 200 μ wide were formed in parallel lines with spaces of 15 μ (215 μ pitch), as shown in Fig. 2. At this time, each of the ITO circuits 3 and 3' was formed so as to have a shape of the teeth of a comb (an interdigital electrode) such that each of the teeth of one comb is intermeshed with the corresponding tooth of the other comb.

2. Electrodeposition coating bath:

(A) Two kinds of aqueous electrodeposition coating bath having the following compositions were prepared.

| Aqueous electrodeposition coating bath | A-1 (g) | A-2 (g) |
|---|---|---|
| Polyester resin (SHINTO-ESTER 30, produced by Shinto Paint Co., Ltd.) | 83 | 83 |
| Butyl Cellosolve (solvent) | 47 | 47 |
| n-butanol (solvent) | 4 | 4 |
| Triethylamine (neutralizer) | 6 | 6 |
| Ion exchange water | 850 | 850 |
| Phthalocyanine blue (pigment produced by Sanyo Shikiso K.K) | 10 | — |
| Paliogen maroon (produced by BASF) | — | 10 |
| Total | 1000 | 1000 |

Each of the electrodeposition coating baths having the above-described compositions was prepared by charging each component except water into a laboratory 3-roll mill (produced by Kodaira Seisakusho), adding a part of water to knead the mixture until the average particle diameter of each pigment was 1 μm (the particle diameter was measured by a Coulter counter N4, produced by Coulter Counter Co.), and adding the remaining water to the thus-kneaded mixture.

(B) Three kinds of nonaqueous electrodeposition coating baths having the following compositions were prepared.

| Nonaqueous deposition coating bath | B-1 (g) | B-2 (g) | B-3 (g) |
|---|---|---|---|
| Nitrocellulose | 3 | 0.3 | — |
| Polyester resin (SHIN-TO-ESTER 30, produced by Shinto Paint Co., Ltd.) | — | — | 16 |
| Opaque white fluorescent pigment (phosphorescent pigment, produced by Kasei Optonics Co.) | 107 | — | — |
| Titanium carbonate (pigment) | — | 10 | — |
| Cyanine green (pigment) | — | — | 10 |
| Diisobutyl ketone (solvent) | 890 | 750 | — |
| Acetone (solvent) | — | 239.7 | — |
| Toluene (solvent) | — | — | 730 |
| Methanol (solvent) | — | — | 244 |
| Total | 1000 | 1000 | 1000 |
| Electric charge doping agent | | | |
| Trimethylammonium hydroxide (10% methanol liquid) | 800 μℓ | 45 μℓ | — |
| Sulfuric acid | 60 μℓ | — | — |
| Calcium naphthenate (50% toluene solution) | — | — | 12 μℓ |
| Resistivity of the bath (Ocm/20°C) | $4.5 \times 10^5$ | $2.8 \times 10^5$ | $6.8 \times 10^9$ |

In order to prepare the nonaqueous electrodeposition coating baths having the above-described compositions, the total amounts of resins and pigments and a part of solvents were weighed and put into a glass container. An appropriate amount of glass media were added thereto and the mixture was dispersed for several hours by a paint conditioner (produced by Igarashi Kikai Seisakusho, Co.) to form a mill base.

The dispersed mill base was added to the remaining solvents with stirring and the respective electric charge doping agents were added with further stirring to obtain the corresponding nonaqueous electrodeposition coating baths.

*Example 1*

A transparent circuit board A having the above-described transparent electric conductive circuits was immersed in the aqueous electrodeposition coating bath A-1, and a stainless steel plate was immersed as the opposing electrode. An electro conductive adhesive tape (copper tape 4, produced by Sony Chemical Co.) of 3 mm wide was pasted to the extending portions of the ITO circuits 2 to cause short-circuiting, as shown in Fig. 1, and a direct current voltage of 30 V was applied for 15 seconds with the copper tape 4 as the positive electrode and the stainless steel plate as the negative electrode. The substrate A was thereafter taken out of the bath and was thoroughly washed and dried with air after the copper tape 4 was peeled thereof. The electrodeposited circuits were colored in blue.

The same copper tape 4' as the copper tape 4 was pasted to the entire part of the ITO circuits 2 and 2' on the substrate A which had been dried with air, as shown in Fig. 3, to cause short-circuiting on a shorter circuit.

The substrate was then immersed in the aqueous electrodeposition bath A-2, electrodeposited with the substrate as the positive pole under the same condition as that of the electrodeposition coating bath A-1, washed with water and dried with air. At this time, no electrodeposited coat produced from the electrodeposition coating bath A-2 was formed on the longer electric conductive circuits 2 which had been electrodeposited in blue in advance in the electrodeposition coating bath A-1, because the blue electrodeposited coats insulated the electric conductive circuits 2.

Three circuits of the adjacent ITO circuits 2' which were not to be colored in blue (the ITO circuits 2' were to be colored in red in the electrodeposition coating bath A-2 which were to be used in the next step) were observed to have been colored in blue at the time of blue coloring in the electrodeposition coating bath A-1 in the first step on the substrate A obtained, and the existence of the short-circuiting portions on both the circuits 2 and 2' was discriminated with the naked eye. When the circuits 2' were colored in red in the electrodeposition coating bath A-2 in the next step, two circuits which were to be colored in red were not colored, so that the disconnected portions were observed with the naked eye.

By cutting the short-circuiting portions with a diamond cutter and modifying the disconnected portions with electric conductive ink under observation of the circuits by a microscope, it was able to modify the circuits to a circuit having a normal function.

After such modification, the substrate was subjected to ultrasonic cleaning in isopropyl alcohol to remove the colored coats.

Another substrate of the same kind was colored in blue and red by the above-described electrodeposition. In this case, the longer ITO circuits 2 were only colored in blue and the shorter circuits 2' were only colored in red, whereby it was easily discriminated that no disconnection nor short-circuiting was produced on the ITO circuits.

*Example 2*

A transparent substrate B having the above-described transparent electric conductive circuits was immersed in the nonaqueous electrodeposition caoting bath B-1, and a stainless steel plate was immersed as the opposing electrode. The copper tape 4 used in Example 1 was pasted to a common electrode 5 of one interdigital ITO circuits 3, as shown in Fig. 4, and a direct current of 400 V was applied for 5 seconds with the copper tape 4 as the positive pole and the stainless steel plate as the negative pole. Thereafter, the substrate B was taken out, washed and dried with air.

The copper tape 4 was pasted on a common electrode 5' of the other interdigital ITO circuits 3' on the opposite side of the ITO circuits 3 on the dried substrate B, and the substrate B was immersed in the nonaqueous electrodeposition coating bath B-2. A voltage of 500 V was applied for 1 second with the copper tape as the positive pole and the stainless steel plate as the negative pole. The substrate was then taken out, washed and dried with air.

Opaque white and black colored films were faithfully formed on alternate lines, respectively, on the ITO circuits on the substrate B obtained, whereby it was easily discriminated with the naked eye that there was no disconnection nor short-circuiting on the ITO circuits.

*Example 3*

A coat was formed on the one interdigital ITO circuits 3 on the substrate B in the nonaqueous electrodeposition coating bath B-1 in the same way as Example 2, and the substrate was washed and dried with air.

Thereafter, the substrate B was immersed in the nonaqueous electrodeposition coating bath B-3 to electrodeposit a film on the other interdigital ITO circuits 3' in the same way. The applied voltage was 100 V and the applying time was 3 seconds in this case.

Opaque white and green colored films were faithfully formed on alternate lines, respectively, on the ITO circuits on the substrate B obtained, whereby it was easily discriminated with the naked eye that there was no disconnection nor short-circuiting on the ITO circuits.

According to the method of the present invention, the conductive circuit portions of a transparent circuit board having transparent electric conductive circuits are faithfully colored, whereby the circuit portions and non-circuit portions are distinctly discriminated. Therefore, it is easy to examine a defective portion with the naked eye. Furthermore, since the circuits are electrically colored, if there is an electric defect, an unnecessary portion is colored (short-circuit) or the necessary portion is not colored (disconnection), so that the presence or absence of a defect is immediately detected. Thus, the method according to the present invention is useful as a method of examining a defect of a transparent circuit board for, for example, a liquid display device, which has recently been made finer and finer.

## Claims

1. A method of detecting the presence or absence of a defect of a transparent circuit board having fine transparent electric conductive circuits comprising the step of coloring said fine transparent electric conductive circuits in an electrodeposition coating bath.

2. A method according to Claim 1, wherein said electrodeposition coating bath is a bath containing a polycarboxylic acid polymer in an aqueous medium.

3. A method according to Claim 1, wherein said electrodeposition coating bath contains a nonaqueous medium and the resistivity of said bath is not more than $10^{11}$ Ωcm.

## Patentansprüche

1. Verfahren zur Ermittlung der An- oder Abwesentheit von Fehlern bei einer transparenten Leiterplatte, welche dünne, transparente, elektrisch leitende Schaltkreise besitzt, wobei der Schritt vorgesehen ist, die feinen, transparenten, elektrisch leitenden Schaltkreise in einem galvanischen Niederschlags-Beschichtungs-Bad zu färben.

2. Verfahren nach Anspruch 1, bei welchem das galvanische Niederschlags-Beschichtungs-Bad ein Bad ist, welches ein Poly-Karbonsäure-Polymer in einem wässerigen Medium enthält.

3. Verfahren nach Anspruch 1, bei welchem das galvanische Niederschlags-Beschichtungs-Bad ein nichtwässeriges Medium enthält und der spezifische Widerstand des Bades nicht mehr als $10^{11}$ Ωcm beträgt.

## Revendications

1. Procédé pour détecter la présence ou l'absence d'un défaut dans une plaquette transparente de circuits imprimés portant des circuits électriquement conducteurs transparents et de faible épaisseur, comprenant l'étape consistant à colorer lesdits circuits électriquement conducteurs transparents et de faible épaisseur dans un bain de revêtement par électrodéposition.

2. Procédé suivant la revendication 1, dans lequel le bain de revêtement par électrodéposition est un bain contenant un polymère d'acide polycarboxylique dans un milieu aqueux.

3. Procédé suivant la revendication 1, dans lequel le bain de revêtement par électrodéposition contient un milieu non aqueux et la résistivité du bain est non supérieure à $10^{11}$ Ωcm.

## FIG.1

## FIG.2

## FIG.3

## FIG.4